# DEMANDE DE BREVET EUROPEEN

(11) **EP 0 838 690 A1**
(43) Date de publication de la demande: **29.04.1998**
(21) Numéro de dépôt: 97402478.8
(22) Date de dépôt: 20.10.1997
(51) Int. Cl.: G01R 33/09

(54) **Procédé de réalistation d'un capteur magnétique magnétorésistif et capteur obtenu par ce procédé**

(30) Priorité: 22.10.1996 FR 9612812
(71) Demandeur: COMMISSARIAT A L'ENERGIE ATOMIQUE, 75015 Paris Cédex 15 (FR)
(72) Inventeur: Fedeli, Jean-Marc, 38400 Saint Martin D'Heres (FR)
(74) Mandataire: Signore, Robert

(57) **Abrégé**

Selon l'invention, le capteur comprend deux guides concentrateurs (32, 34) enterrés dans un substrat (20). Les flancs inclinés de ces guides correspondent aux plans cristallographiques du substrat (20). La magnétorésistance (40) est placée sur le substrat (20), entre les guides (32, 34).

Application à la magnétométrie.

## Description

### Domaine technique

La présente invention a pour objet un procédé de réalisation d'un capteur magnétorésistif et un capteur obtenu par ce procédé. Elle trouve une application notamment en magnétométrie.

### Etat de la technique antérieure

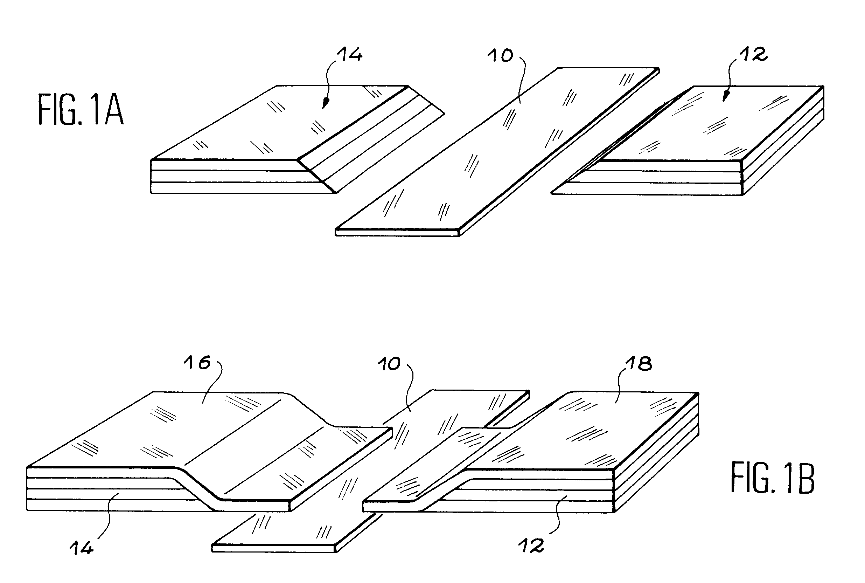

On connaît des capteurs magnétiques constitués par un élément magnétorésistif disposé entre deux guides de flux magnétique destinés à concentrer le champ à mesurer. Dans une variante de ces capteurs, les guides de flux présentent la forme d'un empilement de couches, cet empilement étant gravé pour présenter un flanc incliné. Le document US-A-5,260,653 décrit un tel capteur. Son procédé de réalisation, pour ce qui est des étapes essentielles, est illustré sur les figures 1A et 1B annexées.

Sur la figure 1A, tout d'abord, on voit un ruban magnétorésistif 10 et deux guides de flux 12 et 14 constitués par un empilement de couches magnétiques. Cette figure correspond à une première étape de réalisation où les guides 12 et 14 ont été gravés obliquement.

La figure 1B illustre une deuxième étape, où une couche magnétique a été déposée sur l'ensemble puis gravée pour ne subsister que les parties 16 et 18 surmontant les empilements 12 et 14. Les couches 16 et 18 réalisent un couplage intime à la fois avec les parties épaisses des guides et avec la magnétorésistance qu'elles recouvrent.

Ce procédé de réalisation présente un inconvénient, en ce sens qu'il est difficile de réaliser de tels flancs inclinés par gravure. Cette gravure est, par ailleurs, assez peu reproductible. En outre, cette technique nécessite une couche magnétique supplémentaire pour assurer le couplage (couches 16, 18) et cette couche doit être gravée au-dessus de la magnétorésistance, ce qui n'est guère aisé.

La présente invention a justement pour but de remédier à ces inconvénients.

### Exposé de l'invention

A cette fin, l'invention préconise d'utiliser un substrat cristallin possédant des plans cristallographiques et d'utiliser ces plans pour réaliser les flancs obliques nécessaires à la concentration du flux. De tels flancs peuvent être obtenus très simplement par gravure du substrat cristallin, avec une excellente reproductibilité. Selon une autre caractéristique de l'invention, on enterre les guides de flux dans les caissons à flanc incliné réalisés dans le substrat. La couche magnétorésistive est ensuite formée sur l'ensemble. Il n'y a plus besoin de couche magnétique supplémentaire de couplage.

De façon précise, la présente invention a pour objet un procédé de réalisation d'un capteur magnétique magnétorésistif, caractérisé en ce qu'il comprend les opérations suivantes :
- on part d'un substrat cristallin présentant des plans cristallographiques,
- on grave ce substrat de part et d'autre d'une zone centrale pour obtenir deux caissons aux flancs inclinés selon un plan cristallographique du substrat,
- on remplit ces deux caissons par au moins un matériau magnétique, pour former deux guides de flux magnétique,
- on forme sur le substrat et dans la zone centrale, une magnétorésistance.

De préférence, on forme une magnétorésistance qui chevauche les guides de flux.

Selon une autre variante, avant de former la magnétorésistance, on forme sur les deux guides de flux magnétique une couche magnétique que l'on grave en deux parties et l'on forme ensuite la magnétorésistance qui chevauche ces deux parties magnétiques.

De préférence, après avoir formé la magnétorésistance, on dépose une couche magnétique qui vient chevaucher la magnétorésistance.

De préférence, le substrat est un substrat semiconducteur, par exemple en silicium.

L'invention a également pour objet un capteur magnétique magnétorésistif obtenu par le procédé et comprenant une magnétorésistance disposée entre deux guides de flux magnétique à flancs inclinés, caractérisé en ce que ces guides de flux sont enterrés dans un substrat à plans cristallographiques, les guides de flux remplissant deux caissons formés dans ce substrat de part et d'autre d'une zone centrale, ces caissons présentant des flancs inclinés correspondant à un plan cristallographique du substrat, la magnétorésistance étant disposée sur le substrat dans la zone centrale.

### Brève description des figures

- les figures 1A et 1B, déjà décrites, montrent deux étapes d'un procédé connu de réalisation d'un capteur ;
- la figure 2 montre une première étape d'un procédé conforme à l'invention ;
- la figure 3 montre une autre étape de ce procédé après formation des caissons ;
- la figure 4 montre encore une autre étape de ce procédé, avec remplissage des caissons ;
- la figure 5 montre encore une autre étape de ce procédé permettant l'obtention des deux guides de flux ;
- la figure 6 montre l'étape de formation de la magnétorésistance ;
- la figure 7 illustre une variante utilisant une couche magnétique supplémentaire ;
- la figure 8 illustre encore une autre variante à double chevauchement ;
- la figure 9 montre les variations comparées du signal de mesure pour un capteur de l'art antérieur et pour un capteur selon l'invention ;
- la figure 10 est un agrandissement de la figure 9 ;
- la figure 11 illustre, en vue de dessus, un capteur conforme à l'invention avec une magnétorésistance travaillant en mode transversal ;
- la figure 12 illustre, toujours en vue de dessus, une autre variante à magnétorésistance en méandres fonctionnant en mode longitudinal.

### Exposé détaillé de modes de réalisation

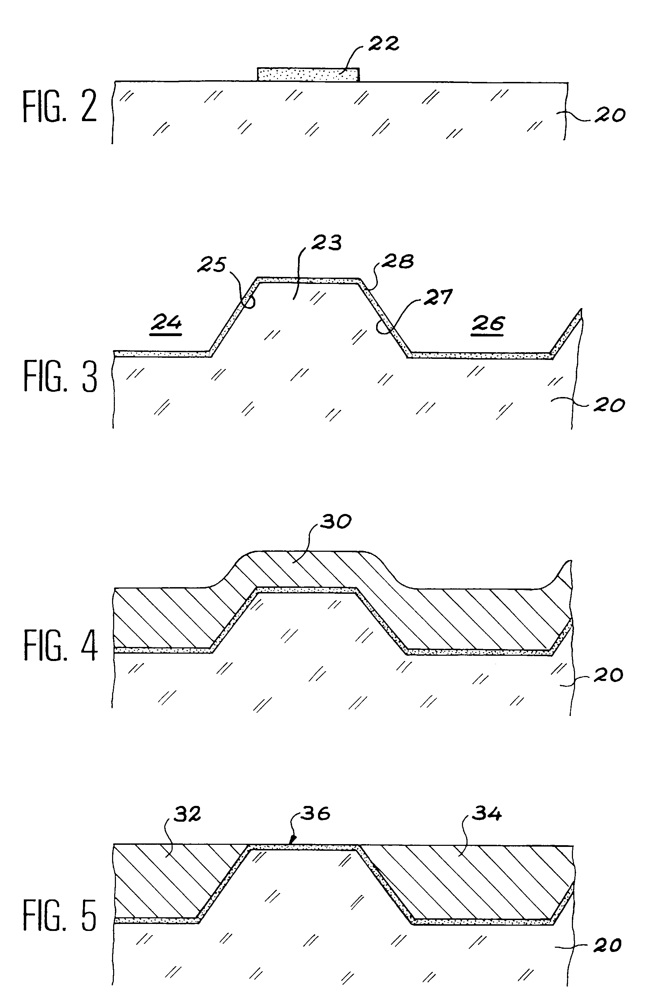

Les figures 2 à 8 illustrent quelques étapes d'un procédé de réalisation d'un capteur conforme à l'invention.

On part d'un substrat 20, par exemple en silicium orienté <100>, sur lequel on dépose un masque en résine 22 (Fig. 2A). Puis on grave chimiquement le substrat, par exemple avec une solution de KOH, pour obtenir deux caissons 24 et 26 aux flancs inclinés, respectivement 25, 27 (Fig. 3). La profondeur de gravure est comprise entre 1 µm et 100 µm ; elle est par exemple de 10 µm environ. Avec le silicium orienté <100> on obtient des flancs inclinés à 55° par rapport à l'horizontale. On élimine alors le masque 22 pour dégager la zone centrale 23 disposée entre les deux caissons.

On réalise ensuite une oxydation thermique pour obtenir une couche d'isolement 28, recouvrant l'ensemble. Cette couche est en SiO₂ dans le cas du silicium. Elle peut avoir une épaisseur de 0,5 µm.

On dépose ensuite une couche magnétique 30 dans les caissons et sur la zone centrale. Ce dépôt peut éventuellement être effectué de manière électrolytique. Dans ce cas, on dépose au préalable une sous-couche conductrice (en Cr ou Au par exemple) et l'on fait croître une couche 30, en Ni ou en Fe-Ni par exemple, sur l'ensemble, sous une épaisseur supérieure à la profondeur des caissons (Fig. 4). On enlève l'excédent de matériau magnétique par polissage de l'ensemble pour mettre à niveau les deux parties magnétiques 32, 34 formant guides de flux et faire apparaître la surface oxydée du substrat dans la zone centrale 36 (Fig. 5).

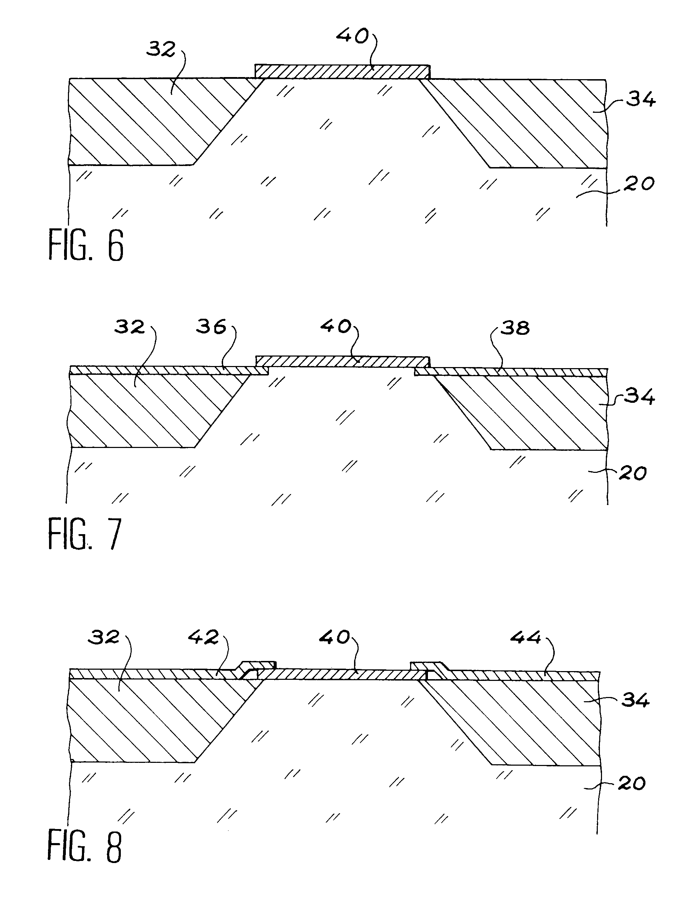

On dépose ensuite une ou plusieurs couches de matériau magnétorésistif d'épaisseur totale inférieure à 100 nm, par exemple par pulvérisation cathodique et l'on grave cette couche (par exemple par usinage ionique) pour ne laisser subsister qu'un ruban 40 (Fig. 6). Ce ruban chevauche légèrement l'extrémité effilée des guides de flux 32 et 34.

Dans une variante de réalisation illustrée sur la figure 7, où les guides de flux 32 et 34 sont davatange écartés l'un de l'autre, on dépose une couche magnétique supplémentaire (par exemple de 0,2 µm d'épaisseur) que l'on grave pour obtenir deux couches 36, 38 recouvrant les guides 32, 34 et dépassant légèrement ceux-ci. La magnétorésistance 40 n'est formée qu'ensuite, et vient chevaucher les couches 36, 38.

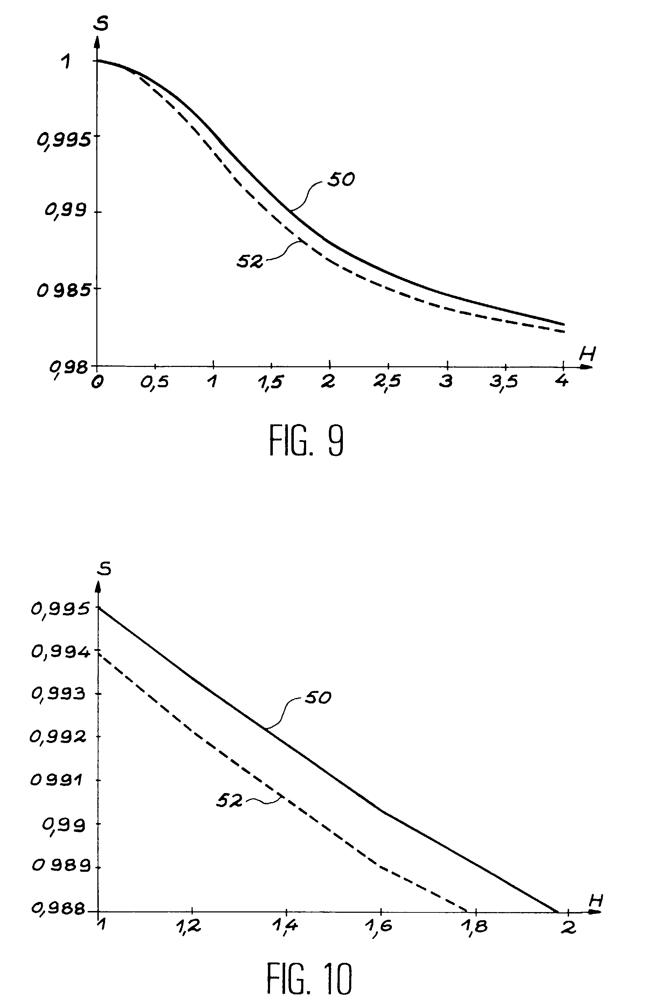

Selon encore une autre variante, illustrée sur la figure 8, après avoir réalisé l'ensemble conforme à la figure 6, on dépose une couche magnétique 42, 44 qui vient chevaucher la magnétorésistance 40. Celle-ci est donc doublement chevauchée, sur ses bords, par les couches 42, 44 et par les guides 32, 34.

Dans cette dernière variante, les couches 42, 44 peuvent être ou non en contact avec les guides 32, 34.

Les figures 9 et 10 permettent de comparer la sensibilité d'un capteur conforme à l'invention avec un capteur de l'art antérieur. Les courbes représentent les variations du signal de mesure S, rapportées à une même unité, en fonction du champ magnétique appliqué H. La courbe 50 est relative à l'art antérieur et la courbe 52 à l'invention dans le cas de la variante à double chevauchement (Fig. 8). Ces courbes montrent que les capteurs selon l'invention sont plus sensibles que ceux de l'art antérieur.

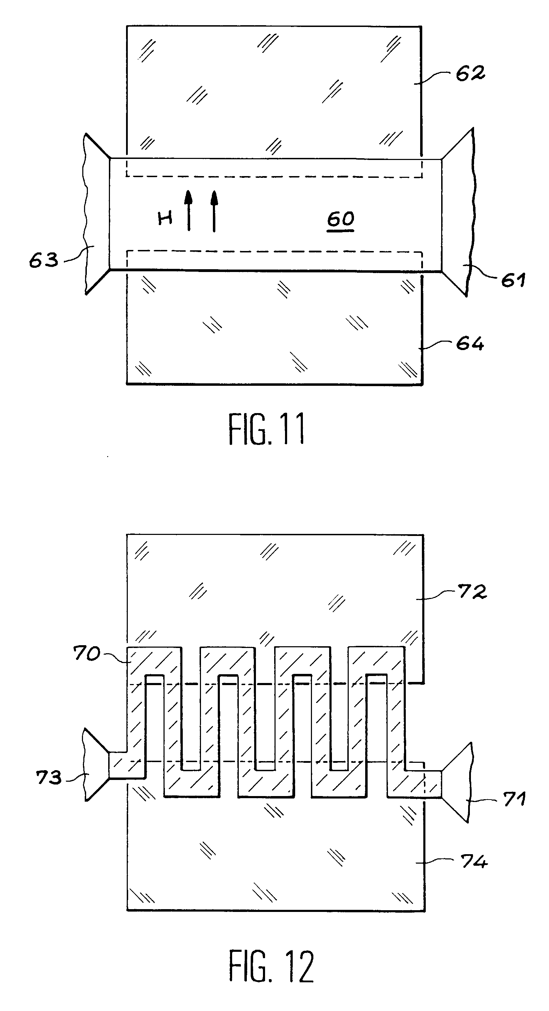

La magnétorésistance utilisée dans l'invention peut être tout type connu : anisotrope, ou GMR (par exemple à valve de spins, etc...). Sa forme peut être quelconque. Sur la figure 11, il s'agit d'un ruban 60 relié à deux connexions électriques 61 et 63. Une telle magnétorésistance fonctionne en mode transversal. Le champ magnétique H est, en effet, perpendiculaire aux grands côtés du ruban, ces grands côtés recouvrant partiellement les deux guides de flux 62 et 64. Dans le cas de la figure 12, la magnétorésistance 70 est un motif en méandres. Ses extrémités sont encore reliées à deux connexions électriques 71, 73 et les guides de flux 72, 74 sont recouverts par les branches horizontales de la magnétorésistance. Celle-ci travaille donc en mode longitudinal, dans ses branches allant d'un guide à l'autre.

## Revendications

1. Procédé de réalisation d'un capteur magnétique magnétorésistif, caractérisé en ce qu'il comprend les opérations suivantes :
- on part d'un substrat cristallin (20) présentant des plans cristallographiques,
- on grave ce substrat (20) de part et d'autre d'une zone centrale (36) pour obtenir deux caissons (24, 26) aux flancs inclinés selon un plan cristallographique du substrat,
- on remplit ces deux caissons par au moins un matériau magnétique, pour former deux guides de flux magnétique (32, 34),
- on forme sur le substrat et dans la zone centrale (36) une magnétorésistance (40).

2. Procédé selon la revendication 1, dans lequel on forme une magnétorésistance (40) qui chevauche les guides de flux (32, 34).

3. Procédé selon la revendication 1, dans lequel, avant de former la magnétorésistance, on forme sur les deux guides de flux magnétique (32, 34) une couche magnétique que l'on grave en deux parties (36, 38) et l'on forme ensuite la magnétorésistance (40) qui chevauche ces deux parties magnétiques (36, 38).

4. Procédé selon la revendication 1, dans lequel après avoir formé la magnétorésistance (40), on dépose une couche magnétique (42) qui vient chevaucher la magnétorésistance (40).

5. Procédé selon l'une quelconque des revendication 1 à 4, dans lequel on part d'un substrat semiconducteur.

6. Procédé selon la revendication 5, dans lequel on part d'un substrat en silicium.

7. Capteur magnétique magnétorésistif obtenu par le procédé de la revendication 1 et comprenant une magnétorésistance (40) disposée entre deux guides de flux magnétique (32, 34) à flancs inclinés, caractérisé en ce que ces guides de flux (32, 34) sont enterrés dans un substrat (20) à plans cristallographiques, les guides de flux (32, 34) remplissant deux caissons formés dans ce substrat (20) de part et d'autre d'une zone centrale (32, 34), ces caissons présentant des flancs inclinés correspondant à un plan cristallograhique du substrat, la magnétorésistance (40) étant disposée sur le substrat, dans la zone centrale.

8. Capteur selon la revendication 7, dans lequel la magnétorésistance (40) chevauche les guides de flux (32, 34).

9. Capteur selon la revendication 7, comprenant en outre deux parties (36, 38) de couche magnétique recouvrant respectivement les deux guides de flux (32, 34), la magnétorésistance (40) chevauchant ces parties (36, 38) de couches magnétiques.

10. Capteur selon la revendication 7, comprenant en outre deux parties (42, 44) de couche magnétique disposées au-dessus des deux guides de flux (32, 34), ces deux parties (42, 44) de couche magnétique chevauchant la magnétorésistance (40).

11. Capteur selon l'une quelconque des revendications 7 à 10, dans lequel le substrat (20) est en semiconducteur.

12. Capteur selon la revendication 11, dans lequel le substrat (20) est en silicium.
